(19)

Europäisches
Patentamt

European
Patent Office

Office européen
des brevets

(11) **EP 4 603 908 A1**

(12) **EUROPEAN PATENT APPLICATION**

(43) Date of publication:
**20.08.2025  Bulletin 2025/34**

(21) Application number: **24158459.8**

(22) Date of filing: **19.02.2024**

(51) International Patent Classification (IPC):
***G03F 1/36*** (2012.01)   ***G03F 1/70*** (2012.01)
***G03F 7/00*** (2006.01)

(52) Cooperative Patent Classification (CPC):
**G03F 1/36; G03F 1/70; G03F 7/70433;
G03F 7/70441**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **IMEC VZW
3001 Leuven (BE)**
• **Katholieke Universiteit Leuven
KU Leuven Research & Development
3000 Leuven (BE)**

(72) Inventors:
• **LEE, Inhwan
3000 Leuven (BE)**
• **FRANKE, Joern-Holger
1160 Auderghem (BE)**
• **PHILIPSEN, Vicky
3080 Tervuren (BE)**

(74) Representative: **Winger
Mouterij 16 bus 101
3190 Boortmeerbeek (BE)**

(54) **SUB-RESOLUTION GRATINGS IN EUV IMAGING**

(57)     The present invention relates to a mask 100 for extreme ultraviolet (EUV) lithography processes in a high or hyper numerical aperture range. The mask 100 includes a mask pattern derived from the superposition of two sub-lay-outs 120, 130. The first sub-lay-out 120 comprises a plurality of mask features intended for printing, with at least one feature oriented along a first direction of the mask lay-out. The second sub-lay-out 130 includes one or more sub-resolution gratings 140 with grating lines that extend substantially in a second direction of the mask lay-out, covering nearly the full width in this second direction. These sub-resolution gratings 140 are designed to be non-printable within the high or hyper numerical aperture range. The invention aims to improve the lithographic performance by optimizing the mask design for specific imaging conditions, such as best focus, highest contrast, and depth of focus through pitch considerations.

**FIG. 1**

**EP 4 603 908 A1**

**Description**

**Technical field of the invention**

The present invention relates to the field of extreme ultraviolet imaging and lithography. More particularly, the present invention relates to masks, methods for designing masks and methods for performing extreme ultraviolet lithography with these masks.

**Background of the invention**

The field of semiconductor manufacturing has seen remarkable advancements over the past decades, with the miniaturization of electronic components being a key driver of technological progress. One of the critical steps in semiconductor fabrication is the process of lithography, which involves transferring intricate patterns onto a silicon wafer to define the various features of integrated circuits. As the demand for smaller and more powerful electronic devices continues to grow, the semiconductor industry is constantly seeking ways to print ever smaller features at high contrast.

Projection lithography technology has been at the forefront of this endeavour, evolving to utilize shorter wavelength light and larger numerical aperture (NA) optics to achieve finer resolution. The introduction of Extreme Ultraviolet (EUV) lithography, with its 13.5nm wavelength, marked a significant leap forward in this respect. However, the quest for even greater resolution has led to the exploration of increasing the NA further. This presents a challenge, as the depth of focus (DoF) is inversely proportional to the square of the NA. Consequently, in high NA (0.55) and hyper NA (larger than 0.75) EUV lithography systems, the DoF becomes extremely limited.

In EUV lithography, the pattern to be printed on the wafer is encoded on a photomask. Due to the unique optical properties at EUV wavelengths, the structures on the mask must be multiples of the wavelength thick, resulting in a three-dimensional mask topology. This complexity leads to variations in the optimal focus position for different pattern pitches on the mask. As all pitches must be printed simultaneously, some will inevitably be out of focus, which is exacerbated as the NA increases.

The industry has explored various technical solutions to address the imaging issues induced by mask three-dimensionality (M3D) in EUV lithography. One common approach is the use of sub-resolution assist features (SRAFs), which are small lines placed parallel to the main features to improve focus variation through pitch and increase normalized image log slope (NILS). However, the placement of SRAFs is complex and requires specialized tools. Moreover, SRAFs can sometimes print unintentionally, leading to defects and increased stochastic failure rates.

Another approach to reduce best focus shifts is to alter the mask material. Low refractive index (low-n) absorber materials with modest absorption have been considered for their potential benefits, including increased reflectivity and diffraction efficiency, which can lead to sharper images. However, these materials also introduce new challenges, such as a drift in best focus for larger pitches, which can sometimes worsen the overall focus range compared to standard mask materials.

Despite these efforts, the industry continues to face significant challenges in EUV mask technology. The variations in best focus across different pitches and the quest for higher NILS remain critical issues that need to be addressed. As the semiconductor industry pushes the boundaries of what is possible with EUV lithography, there is a clear and ongoing need for further advancements in mask technology to overcome these challenges and enable the continued scaling of electronic devices.

**Summary of the invention**

It is an object of the present invention to improve the overall process window for multiple features when using imaging using a numerical aperture of 0.55 or higher.

It is an advantage of embodiments of the present invention that aligned best focus through pitch and better image contrast through pitch can be obtained for EUV lithography.

It is an advantage of embodiments of the present invention that these are compatible with any kind of mask. When mask absorber stacks are used, typically the reflectivity of the absorber stacks may be selected such that the sub-resolution patterns of manufacturable size lead to appropriate background intensity of the absorber patterned with sub-resolution features.

The above objective is accomplished by a method and apparatus according to the present invention.

In the first aspect, the present invention relates to a mask for EUV lithography processes in a high or hyper numerical aperture range, the mask comprising a mask pattern according to a mask lay-out being the superposition of a first mask sub-lay-out comprising a plurality of mask features to be printed, the plurality of mask features to be printed comprising at least one mask feature oriented along a first direction of the mask lay-out, and a second mask sub-lay-out comprising one or more sub-resolution gratings having sub-resolution grating lines, the sub-resolution grating lines extending substantially in a second direction of the mask lay-out and running over substantially the full width in the second direction of the mask lay-out, the one or more sub-resolution gratings not being printable for the high or hyper numerical aperture range.

The sub-resolution grating pitch (SRGpitch) for the one or more sub-resolution gratings (SRGs) typically may be selected to be out of the resolution limit of the EUV lithography processes. The sub-resolution gratings thus do not interfere with the intended mask pattern by remaining unprinted.

The size for the sub-resolution grating lines may be selected based on best focus. This allows optimizing the focus across various pitches, thereby improving the overall quality of the lithography process. The size for the sub-resolution grating lines may also be selected based on highest contrast. This provides the advantage of enhancing the image contrast.

The sub-resolution grating pitch of the one or more sub-resolution gratings may be selected based on depth of focus through pitch for patterns to be printed. The sub-resolution grating pitch of the one or more sub-resolution gratings may also be selected based on highest contrast through pitch for patterns to be printed. This allows achieving high contrast across various pitches for patterns to be printed.

The combination of the sub-resolution grating pitch and size of the sub-resolution grating lines of the one or more sub-resolution gratings thus may be selected based on best depth of focus through pitch and/or highest contrast through pitch for patterns to be printed.

The second mask sub-lay-out may comprise no sub-resolution grating at a position of gaps between the plurality of mask features in the first sub-lay-out.

The first direction may in some embodiments be the same as the second direction.

In some embodiments, the first direction may be different from the second direction.

The grating lines may cross substantially all mask features.

In embodiments, the first direction may be perpendicular to the second direction.

In embodiments, the mask may be for use in a EUV lithography tool using an anamorphic optics system in which demagnification for an X-direction is smaller than demagnification in the Y direction. The first direction along which the plurality of mask features are extending may correspond with the Y direction and the second direction may correspond with the X direction.

It is an advantage of embodiments of the present invention that these are compatible with various shapes of illumination sources used in EUV scanners or lithography.

It is an advantage of embodiments of the present invention that using sub-resolution gratings stabilizes the 0th order phase through pitch for patterns to be printed.

It is an advantage of embodiments of the present invention that by using sub-resolution gratings, the image contrast, e.g. the NILS which is a metric for the image contrast, is substantially uniformly high in all pitch regions for patterns to be printed. Such a NILS is not obtained without the use of sub-resolution gratings. Although a slight reduction in NILS can be seen at small pitch, overall the NILS is far more substantially uniform and high in all pitch regions for patterns to be printed.

It is an advantage of embodiments of the present invention that they can be immediately applicable for high-numerical aperture lithography for currently manufacturable dimensions.

It is an advantage of embodiments of the present invention that they can be applied for the manufacturing of e.g. 2D metal patterns of logic, as well as for 1D metal designs containing L/S and line ends or 1,5D Metal designs containing landing pads.

It is an advantage of embodiments of the present invention that they can be applied for imaging of 2D geometries like contact holes or logic via layers.

It is an advantage of embodiments of the present invention that it can enhance depth-of-focus by reducing the complexity of the best focus problem that often dominates source choice. It is an advantage of embodiments of the present invention that they assist in improving the depth of focus, which is a critical element when using e.g. hyper numerical aperture lithography.

It is an advantage of embodiments of the present invention that these are combinable with other techniques such as fading correction, thus allowing further optimization of the imaging and of the mask stack used at the same time.

It is an advantage of embodiments of the present invention that mask types could be used with a highly reflective absorber, whereby the best focus shift for isolated features is mitigated with the SRGs and whereby pole-to-pole offset is mitigated via fading correction. In this way one could optimize for aligned best focus, high NILS for all features and e.g., high total reflectivity as well as low intensity in the dark region.

It is an advantage of embodiments of the present invention that the use of sub resolution gratings results in an overall brighter mask.

In the second aspect, the present invention relates to a computer-implemented method for designing a mask lay-out for EUV lithography processes in a high or hyper numerical aperture range, the method comprising defining a mask lay-out for the mask pattern as a superposition of a first mask sub-lay-out comprising a plurality of mask features to be printed, the plurality of mask features to be printed comprising at least one mask feature oriented along a first direction of the mask lay-out, and a second mask sub-lay-out comprising one or more sub-resolution gratings having sub-resolution grating lines, the sub-resolution grating lines extending substantially in a second direction of the mask lay-out, and running over substantially the full width in the second direction of the mask lay-out, the one or more sub-resolution gratings being not printable for the high or hyper numerical aperture range.

In embodiments, the method may comprise repeating said defining a mask lay-out for a plurality of sub-resolution grating pitches and/or sizes of the sub-resolution grating lines of the one or more sub-resolution gratings thus obtaining different mask lay-outs as function of the size of the sub-resolution grating lines, simulating lithographic imaging of the mask pattern for each of said different mask lay-outs as function of the sub-resolution pitch and the size of the sub-resolution grating lines thus obtaining imaging quality parameters, and selecting the mask lay-out having the best imaging quality parameters. The imaging quality parameters may for example be depth of focus through pitch and/or highest contrast through pitch for the patterns to be printed. This embodiment provides the advantage of enabling the selection of an optimal mask lay-out through simulation, which can lead to improved lithographic results.

The method may further comprise simulating lithographic imaging as function of multiple monopole exposure passes or injected aberrations. This embodiment provides the advantage of accounting for various lithographic conditions, which can lead to a more robust and reliable mask design.

In a third aspect, the present invention relates to a system for determining lithographic processing conditions for EUV lithography processes in a high or hyper numerical aperture range, the system comprising an input means for obtaining characteristics of an illumination source and of a lithography pattern to be created, and a processing means programmed for defining a mask lay-out for the mask pattern as a superposition of a first mask sub-lay-out comprising a plurality of mask features to be printed, the plurality of mask features to be printed comprising at least one mask feature oriented along a first direction of the mask lay-out, and a second mask sub-lay-out comprising one or more sub-resolution gratings having sub-resolution grating lines, the sub-resolution grating lines extending substantially in a second direction of the mask lay-out and running over substantially the full width in the second direction of the mask lay-out, the sub-resolution grating further not being printable for the high or hyper numerical aperture range. The system furthermore typically comprises an output system for outputting the designed or selected mask lay-out.

The processing means may furthermore be programmed for repeating said defining a mask lay-out for a plurality of sub-resolution grating pitches and/or sizes of the sub-resolution grating lines thus obtaining different mask lay-outs as function of the sub-resolution grating pitch and as function of the size of the sub-resolution grating lines, simulating lithographic imaging of the mask pattern for each of said different mask lay-outs as function of the sub-resolution grating pitch and the size of the sub-resolution grating lines thus obtaining imaging quality parameters, and selecting the mask lay-out having the best imaging quality parameters. The imaging quality parameters may for example be depth of focus through pitch and/or highest contrast through pitch for the patterns to be printed.

The system may be implemented as a computer program product for, when executing on a processing means, carrying out one of the methods according to the second aspect of the invention.

In a further aspect, the present invention relates to a data carrier storing a computer program product, when executed on a processing means, carrying out one of the method according to the second aspect of the invention.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig.1 is a schematic representation of a mask for EUV lithography processes according to embodiments of the present invention.

Fig.2 is a flow diagram of a computer-implemented method for designing a mask lay-out for EUV lithography processes according to an exemplary embodiment of the present invention.

FIG. 3 is a system for designing a mask lay-out for EUV lithography processes, according to embodiments of the present invention.

FIG. 4 to FIG. 8 illustrate examples of the use of a sub-resolution grating in a mask lay-out for obtaining improved EUV lithography masks and resulting advantages thereof.

In the different drawings, the same reference signs refer to the same or analogous elements.

**Detailed description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of', is also encompassed within the scope of the present invention.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

Where reference is made to "a mask for EUV lithography processes", reference is made to a photomask specifically designed for use in extreme ultraviolet (EUV) lithography systems that operate with a high or hyper numerical aperture (NA). Where reference is made to high numerical aperture (NA), reference is made to a numerical aperture of more than 0.5. Where reference is made to hyper numerical aperture, reference is made to a numerical aperture of more than 0.55.

Where reference is made to "pitch for the one or more sub-resolution gratings" or sub-resolution grating pitch, this refers to the distance between the centers of adjacent lines or features within the sub-resolution grating pattern. The sub-resolution grating pitch is selected to be beyond the resolution capability of the EUV lithography process, meaning that the individual lines or features of the grating will not be distinctly printed on the substrate. Examples of specific embodiments include sub-resolution grating pitches that are greater than the minimum feature size that the lithography system can resolve, which may vary depending on the specific capabilities of the EUV lithography equipment being used.

Where reference is made to "pole-to-pole offset", reference is made to the technique whereby the pattern shift resulting from illumination from different illumination poles is used for pushing the resolution limit.

As used herein, and unless otherwise specified, the term "size for the sub-resolution grating lines" refers to the width or critical dimension of the individual lines or features that make up the sub-resolution grating pattern on the mask.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a mask for EUV lithography processes in a high or hyper numerical aperture range. Whereas masks for EUV lithography typically are used at one specific numerical aperture and thus typically are designed therefore, masks as referred to in the present invention could be made hybrid, i.e. for use in different tools having different NA. In such cases, the frames of the mask could for example comprise different alignment marks for different NA tools.

The mask according to embodiments of the present invention can be any type of EUV lithography mask. It may be a bright field mask or a dark field mask. The mask may be made of any suitable material. In some embodiments, the mask may be made of low-n material, but embodiments are not limited thereto.

The mask manufacturing that will be formed based on the determined mask design can be any conventional EUV mask manufacturing technology. The mask may be made using e-beam writing technology. The mask features and the one or more sub-resolution gratings that will be defined below could in some embodiments be implemented in multiple processing steps or simultaneously, e.g. implementing e-beam writing and etching.

The mask comprises a mask pattern, which will typically be a pattern formed by mask material on a substrate. The mask pattern thereby is made according to a mask lay-out.

According to embodiments of the present invention, the mask lay-out is a superposition of a first mask sub-lay-out and a second mask sub-lay-out.

In other words, the mask lay-out is the result of overlaying or combining multiple individual patterns or sub-lay-outs. The first mask sub-lay-out comprises a plurality of mask features to be printed. This plurality of mask features to be printed comprises at least one mask feature oriented along a first direction of the mask lay-out. This refers to the portion of the mask pattern that includes the primary features intended to be transferred onto the wafer or substrate during the lithography process. These features represent the actual patterns or device structures that are required for the final manufactured product. Examples of specific embodiments include, but are not limited to, lines, spaces, contact holes, and other geometric shapes that correspond to the elements of an integrated circuit or other devices.

The second mask sub-lay-out comprises one or more sub-resolution gratings having sub-resolution grating lines. The one or more sub-resolution gratings may have a different sub-resolution grating pitch or the same sub-resolution grating pitch. If different sub-resolution grating pitches are used for different sub-resolution gratings, optimisation may be performed for each of them. The sub-resolution grating lines of the one or more sub-resolution gratings extend substantially in a second direction of the mask lay-out and run over substantially the full width in the second direction of the mask lay-out. The one or more sub-resolution gratings are not printable for the high or hyper numerical aperture range for which the mask is used. The sub-resolution grating lines thus only include grating lines with dimensions below the resolution limit of the lithography system, such that they do not print as distinct features on the wafer.

The resulting mask lay-out that is used for manufacturing the corresponding mask, may in a final representation be a binary representation, i.e. the combination of mask features and sub-resolution grating lines being expressed only as 0 and 1. Here, 0 represents a dark area (=absorbing area) where light is absorbed, and 1 represents a bright area (=reflecting area) where light is reflected.

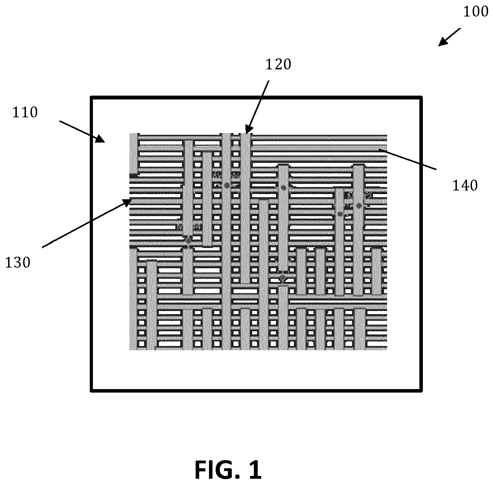

FIG. 1 illustrates a mask lay-out 110, by way of illustration shown as the corresponding pattern on a substrate resulting in a mask 100. In FIG. 1, the mask lay-out 110 is a superposition of a first mask sub-lay-out 120 comprising the mask features intended for printing, and a second mask lay-out 130 comprising one or more sub-resolution gratings 140, not intended for occurring as printed features in the final substrate.

In some embodiments, the first direction may be the same as the second direction. One example of such an embodiment is wherein horizontal metal designs at a pitch of 20nm are combined with a sub-resolution grating having sub-resolution grating lines at a sub-resolution grating pitch of 10nm. Advantage of such an embodiment is that this solves the 2-bar critical dimension asymmetry through focus occurring for horizontal metal design (lines extending along the X direction) by using manufacturable sub-resolution gratings extending along X direction in cases where sub-resolution gratings extending along Y direction would not be manufacturable.

In some embodiments, the first direction may be different from the second direction. This covers for example the case where the pattern design to be printed is rotated with respect to the direction of the sub-resolution grating direction.

In some embodiments, the first and the second direction may be perpendicular to each other. In such embodiments, advantage can be taken of another aspect of EUV lithography. In EUV lithography, increasing the NA implies that the angles at which the radiation hits the mask increase resulting in a loss of reflectivity in which leads to printing issues. This issue has been addressed in the field by the use of anamorphic optics. Rather than uniformly shrinking the pattern to be printed, the reflective optics of the EUV system used demagnifies the pattern to be printed differently in one direction compared to the direction perpendicular thereto. A typical demagnification in EUV lithography systems used is a demagnification for an X-direction being smaller than the demagnification in the Y direction. An example of such a system includes a demagnification in X-direction being 4x and a demagnification in Y-direction being 8x.

Since the scale of the mask is relatively large for the Y direction, it allows us to have a relaxed and design friendly layout. Taking advantage of this anamorphic optics design system, in some embodiments the sub-resolution grating lines can be easily inserted with its pitch in the Y direction (i.e., lines extending along the X direction) without the risk of violation of the mask rule checks (MRC). It does not cause the unwanted printability issue of sub-resolution features because it uses patterns outside the resolution limit. Consequently, in some embodiments, the first direction along which the plurality of mask features are extending corresponds with the Y direction and the second direction corresponds with the X direction.

In some embodiments according to the present invention, the mask's design is further tuned by selecting the sub-resolution grating pitch and size of the sub-resolution grating lines based on factors such as best focus, highest contrast, and depth of focus through pitch for patterns to be printed. These selections allow for optimizing the lithography process, as they enhance image quality and uniformity across various pitches. According to some specific embodiments, the size of the grating lines of the one or more sub-resolution gratings is selected based on best imaging performance. This can vary on the mask tonality and mask stack (absorber thickness, absorber material's refractive indices). The sub-resolution grating pitch of the one or more sub-resolution gratings is selected to be out of resolution limit, which guarantees that there is no risk of unwanted sub features printability on the wafer. It furthermore takes into account the mask manufacturing feasibility. The sub-resolution grating pitch can be further relaxed or fine-tuned if the maximum sigma-y point of illumination pupil can be reduced to a smaller value. By way of illustration, embodiments of the present invention not being limited thereto, the allowable sub-resolution grating pitch can be expressed as

$$\frac{\lambda}{NA * (1 + \sigma_{Ymax})} > pitch_{sub-resolution\ grating}$$

where $\lambda$ is the wavelength of the EUV lithography processes and $\sigma_{Ymax}$ is the maximum sigma-y point of the illumination pupil. If for example the maximum sigma-y point of the illumination pupil $\sigma_{Ymax}$ is 0.8, the minimal pitch can be 10nm, whereas if the maximum sigma-y point of the illumination pupil $\sigma_{Ymax}$ is 1, the minimal pitch can be 9nm. If the current achievable minimum width that can be drawn on the mask using e-beam writing technology is 24nm to 32nm, this could result - in an image scale with 8X magnification - in 3 - 4 nm. For 0.55NA, the resolution limit then is 12.3nm pitch at wafer scale, so 98.2nm at mask scale in the Y direction. For 0.75NA, the resolution limit is 9nm pitch at wafer scale, 72nm at mask scale in the Y direction. Printable features on mask are therefore much smaller than the smallest periodicity that could potentially be imaged by the high-NA or hyper-NA tools, especially if the grating is oriented as horizontal lines (which are magnified by 8x).

According to some embodiments, sub-resolution gratings having grating lines running over substantially the full width of the mask are implemented in some areas of the mask, but no sub-resolution gratings are provided in areas where gaps exist between mask features to be printed, simplifying the design where gratings are unnecessary.

In a second aspect, the present invention relates to a computer-implemented method for designing a mask lay-out for EUV lithography processes in a high or hyper numerical aperture range. The method may result in a mask for EUV lithography processing as described in the first aspect. According to embodiments of the present invention, the method comprises defining a mask lay-out for the mask pattern as a superposition of a first mask sub-lay-out and a second mask sub-lay-out. The first mask sub-lay-out comprises a plurality of mask features to be printed, the plurality of mask features to be printed comprising at least one mask feature oriented along a first direction of the mask lay-out. The second mask sub-lay-out comprises one or more sub-resolution gratings having sub-resolution grating lines, the sub-resolution grating lines extending substantially in a second direction of the mask lay-out, and running over substantially the full width in the second direction of the mask lay-out, the one or more sub-resolution gratings being not printable for the high or hyper numerical aperture range.

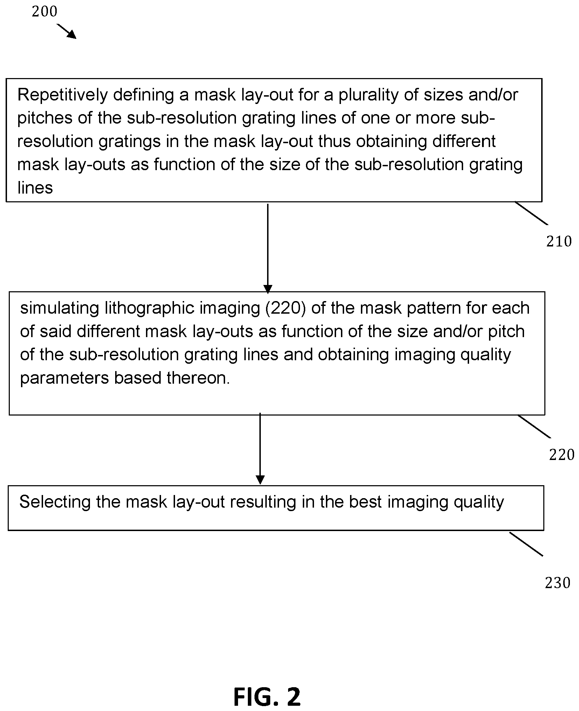

In one exemplary embodiment, as shown in FIG. 2, a method is disclosed wherein the method 200 comprises the following steps.

In a first step, the method 200 comprises repetitively defining a mask lay-out 210 having the mask lay-out features as described above but for a plurality of sub-resolution grating pitches and/or sizes of the sub-resolution grating lines of the one or more sub-resolution gratings thus obtaining different mask lay-outs as function of the sub-resolution grating pitch and/or size of the sub-resolution grating lines.

In a second step, the method 200 comprises simulating lithographic imaging 220 of the mask pattern for the different mask lay-outs as function of the size of the sub-resolution grating lines. From such simulations imaging quality parameters can be derived. These can be e.g. best depth of focus through pitch and/or highest contrast through pitch for patterns to be printed, but could also include other imaging quality parameters.

In a third step, the method 200 comprises selecting the mask lay-out 230 having the best imaging quality parameters.

It is to be noted that the steps may be performed at least partly in parallel and that based on a first evaluation, certain mask lay-outs may not be considered anymore while other mask lay-outs may be defined and simulated with preference.

The method may be implemented as an optimization method for thus obtaining an improved mask lay-out.

According to embodiments of the present invention, these thus involve defining 210 multiple mask lay-outs with varying sub-resolution grating pitches and/or sizes of the sub-resolution grating lines, simulating lithographic imaging 220 for the lay-outs, and selecting 230 the one with the best depth of focus and/or highest contrast through pitch of the patterns to be printed. Aside from these optimisations, the method may also account for different lithographic conditions, such as multiple monopole exposure passes or injected aberrations. Further optimization of the mask design, based on other known optimization processes could also be implemented simultaneously or in addition thereto.

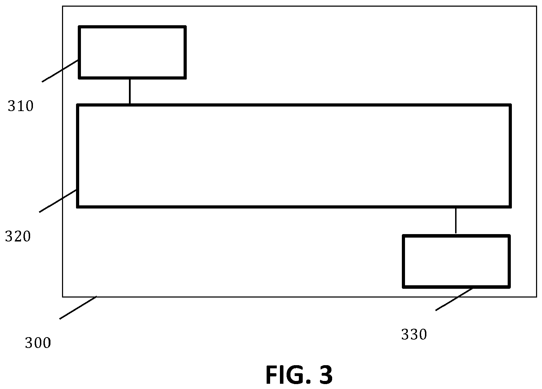

In a third aspect, a corresponding system for performing a method as described in the second aspect is disclosed. This system for determining lithographic processing conditions, includes input means for obtaining characteristics of an illumination source and a lithography pattern, and processing means for defining a mask lay-out to be used. An output means for outputting the defined or selected mask lay-out also is included. In some embodiments, the processing means may be programmed for defining mask lay-outs with different sub-resolution grating pitches and sizes of sub-resolution grating lines, for simulating lithographic imaging for each lay-out and for selecting the one offering the best depth of focus through pitch and/or highest contrast through pitch, thus providing a further systematic approach to mask design. Such a system may be implemented as a computer program product and a data carrier storing such a program, respectively. These aspects may be specifically designed for enabling the execution of the methods described in the second aspect of the invention, facilitating the design and optimization of mask lay-outs for EUV lithography processes. An exemplary system is shown in FIG. 3, illustrating the system 300 with the input means 310, the processing means 320 and the output means 330.

By way of illustration, embodiments not being limited thereto, the invention will further be illustrated by some examples and considerations, showing standard and/or optional features of embodiments of the present invention as well as corresponding advantages.

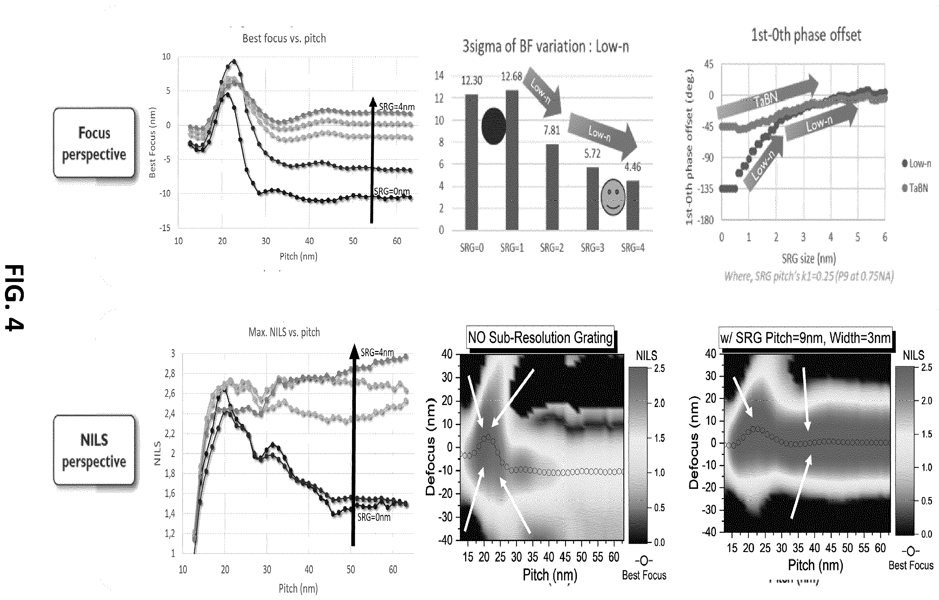

In a first example, the effects of adding sub-resolution gratings of various widths to mask features on a mask are shown in FIG. 4. The results are shown from the perspective of best focus as well as from the perspective of NILS. FIG. 4 shows (from left to right - upper row) the best focus shift through pitch for mask features for a low-n mask, the 3sigma of the best focus variation and the 1st - 0th order phase offset. The pitch of the sub-resolution grating used thereby is SRGpitch = 9nm at wafer scale. In the left drawing of the upper row, the width of the sub-resolution grating lines thereby varies from 0nm (no sub-resolution grating) to 4nm at wafer scale, the arrow indicating the direction of increase of the width of the SRG lines.

FIG. 4 also shows (from left to right - bottom row) the Nils through pitch for mask features, the NILS as function of pitch and defocus when no sub-resolution grating is used and the NILS as function of pitch and defocus when a sub-resolution grating with SRGpitch 9nm and sub-resolution grating line width of 3nm. In the left drawing of the bottom row, the arrow indicates the direction of increasing SRG width (no SRG lines, SRG width = 1 nm to SRG width 4nm). In the middle and the right drawing of the bottom row, the arrows indicate the direction of increasing NILS.

From these results, it can be seen that the application of a sub-resolution grating in a mask results in advantageous lithography processes when using such mask.

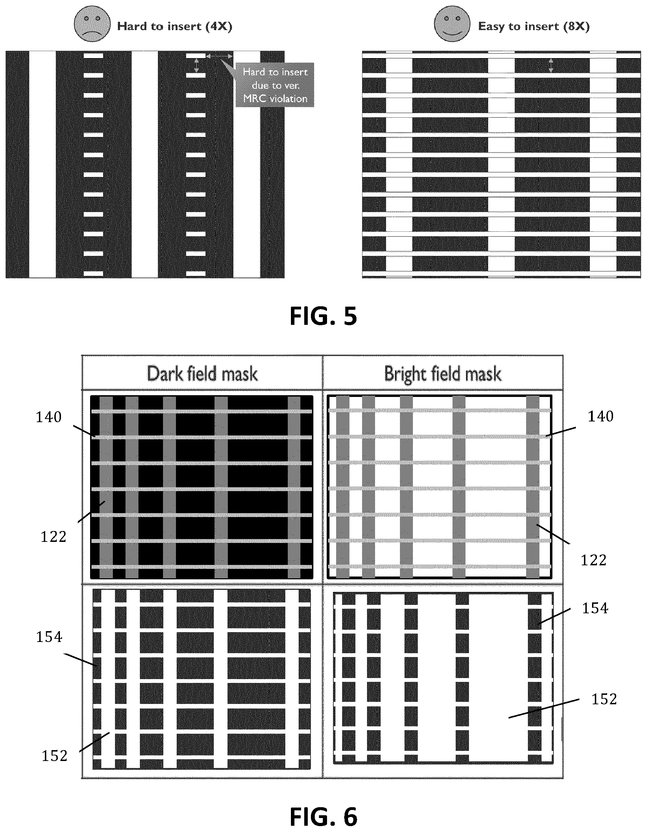

In a second example, the effects of tuning the use of a sub-resolution grating in the mask lay-out to the imaging conditions of the EUV lithography on the mask rule checks typically applied are illustrated. In the example shown, the lay-out includes horizontal sub-resolution grating lines perpendicular to the vertical main features. FIG. 5 at the left shows that the use of sub-resolution assisted features separated from the vertical pattern would result in tight mask rule checks, whereas FIG. 5 at the right illustrates that sub-resolution grating lines cutting through all mask features avoid mask rule check issues. The situation is illustrated for the use of sub-resolution gratings for a dark field mask. FIG. 5 shows a representation of a sub-resolution grating for a dark field mask and a bright field mask. In the case of a bright field mask, the tone of the sub-resolution grating is inverted for improving the imaging performance.

Aside from the transmittance, drawn in the bottom portion of FIG. 6, also a representation of the mask features is shown in the upper portion of FIG. 6. In FIG. 6, the mask features 122 and the sub-resolution gratings 140 are indicated in the upper portion illustrating the masks drawn by layers. Furthermore, in the lower portion illustrating the masks drawn by transmission, the reflective portion 152 (induced by a multilayer) and the absorbing portion 154 (induced by the absorber) are shown.

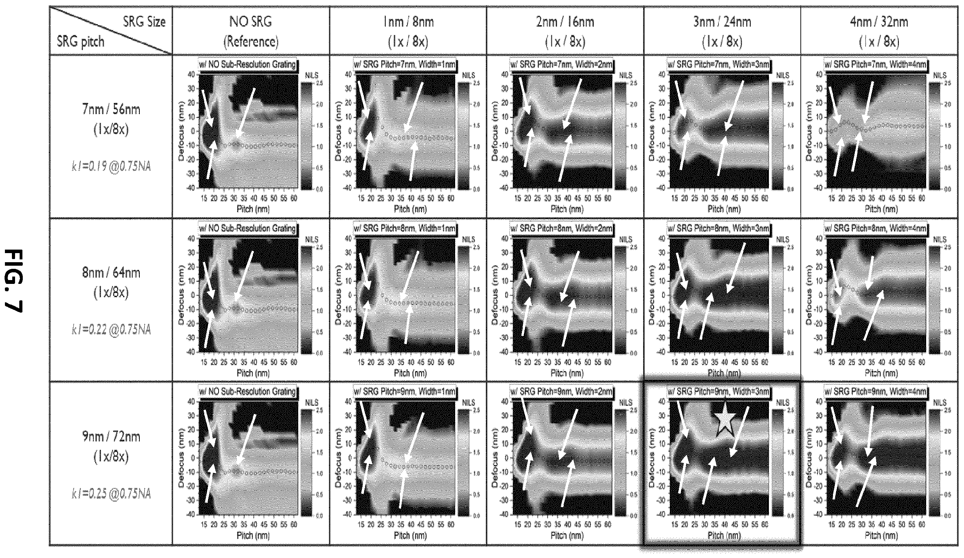

In a further example, the optimization of the size and pitch of the sub-resolution grating lines is illustrated. In the example different sub-resolution sizes at wafer scale are evaluated as function of different sub-resolution grating pitch. In FIG. 7, the situation is shown wherein no sub-resolution grating is used, and for the use of a sub-resolution grating having a sub-resolution grating line width at wafer scale of 1nm, 2nm, 3nm and 4nm. This situation is shown for a sub-resolution grating pitch of 7nm, 8nm and 9nm at wafer scale. In the drawings, the arrows indicate the direction of increasing NILS. From the drawing, it can be seen that the best performance for both image contrast and best focus through pitch is obtained for a sub-resolution grating pitch of 9nm at wafer scale and a sub-resolution grating line size of 3nm at wafer scale.

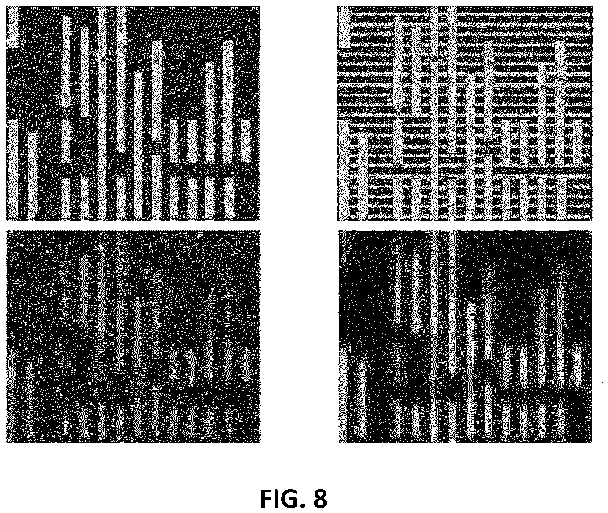

In a fourth example, the impact of the use of a sub-resolution grating in the mask lay-out for a 1D Metal design lay-out (mask design shown in the upper portion of FIG. 8) on the resulting image (shown in the bottom portion of FIG. 8 is shown. In the left portion of FIG. 8, the result is shown for a mask design without sub-resolution grating whereas in the right portion of FIG. 8 the result is shown for a mask design with sub-resolution grating. It can be seen that the sub-resolution grating is not visible in the image, but significantly improves the pattern image. It can also be seen that the background intensity is decreased, thus reducing the propensity for defects in EUV lithography.

**Claims**

1. A mask (100) for EUV lithography processes in a high or hyper numerical aperture range, the mask (100) comprising a mask pattern according to a mask lay-out (110) being the superposition of

   - a first mask sub-lay-out (120) comprising a plurality of mask features to be printed, the plurality of mask features to be printed comprising at least one mask feature oriented along a first direction of the mask lay-out,
   - a second mask sub-lay-out (130) comprising one or more sub-resolution gratings (140) having sub-resolution grating lines, the sub-resolution grating lines extending substantially in a second direction of the mask lay-out (110) and running over substantially the full width in the second direction of the mask lay-out (110), the one or more sub-resolution gratings (140) not being printable for the high or hyper numerical aperture range.

2. A mask (100) according to claim 1, wherein the size for the sub-resolution grating lines is selected based on best focus and/or highest contrast.

3. A mask (100) according to any of the previous claims, wherein the pitch for the one or more sub-resolution gratings (140) is selected to be out of the resolution limit of the EUV lithography processes.

4. A mask (100) according to claim 3, wherein the combination of the sub-resolution grating pitch and size of the sub-resolution grating lines of the one or more sub-resolution gratings (140) is selected based on best depth of focus through pitch and/or highest contrast through pitch.

5. A mask (100) according to any of the previous claims, wherein the second mask sub-lay-out (130) comprises no sub-resolution grating at a position of gaps between the plurality of mask features in the first sub-lay-out (120).

6. A mask (100) according to any of the previous claims, wherein the first direction is different from the second direction and wherein the sub-resolution grating lines cross substantially all mask features, or wherein the first direction is perpendicular to the second direction.

7. A mask (100) according to the previous claim, wherein the mask is one of a dark field mask or a bright field mask.

8. A mask (100) according to any of the previous claims, the mask (100) being for use in a EUV lithography in a high or hyper numerical aperture range and an anamorphic optics system in which demagnification for an X-direction is smaller than demagnification in the Y direction, wherein the first direction along which the plurality of mask features are extending corresponds with the Y direction and the second direction corresponds with the X direction.

9. A computer-implemented method (200) for designing a mask lay-out for EUV lithography processes in a high or hyper numerical aperture range, the method comprising

defining a mask lay-out (110) for the mask pattern as a superposition of a first mask sub-lay-out (120) comprising a plurality of mask features to be printed, the plurality of mask features to be printed comprising at least one mask feature oriented along a first direction of the mask lay-out, and

a second mask sub-lay-out (130) comprising one or more sub-resolution gratings (140) having sub-resolution grating lines, the sub-resolution grating lines extending substantially in a second direction of the mask lay-out, and running over substantially the full width in the second direction of the mask lay-out (110) , the one or more sub-resolution gratings (140) being not printable for the high or hyper numerical aperture range.

10. A computer-implemented method (200) according to claim 9, wherein the method comprises

- repetitively defining a mask lay-out (210) for a plurality of sub-resolution pitches and/or sizes of the sub-resolution grating lines of the one or more sub-resolution gratings thus obtaining different mask lay-outs,
- simulating lithographic imaging (220) of the mask pattern for each of said different mask lay-outs as function of the sub-resolution pitch and size of the sub-resolution grating lines thereby obtaining image quality parameters, and
- selecting the mask lay-out (230) having the best image quality parameters.

11. A computer-implemented method (200) according to any of claims 9 to 10, wherein the method (200) further comprises simulating lithographic imaging as function of multiple monopole exposure passes or injected aberrations..

12. A system (300) for determining lithographic processing conditions for EUV lithography processes in a high or hyper numerical aperture range, the system comprising

- an input means (310) for obtaining characteristics of an illumination source and of a lithography pattern to be created,
- a processing means (320) programmed for

  ○ defining a mask lay-out for the mask pattern as a superposition of

    ▪ a first mask sub-lay-out comprising a plurality of mask features to be printed, the plurality of mask features to be printed comprising at least one mask feature oriented along a first direction of the mask lay-out, and
    ▪ a second mask sub-lay-out comprising one or more sub-resolution gratings having sub-resolution grating lines, the sub-resolution grating lines extending substantially in a second direction of the mask lay-out and running over substantially the full width in the second direction of the mask lay-out, the sub-resolution grating further not being printable for the high or hyper numerical aperture range, and

- an output means (330) for outputting the mask lay-out.

13. A system (300) according to claim 12, wherein the processing means furthermore is programmed for

- repeating said defining a mask lay-out for a plurality of sub-resolution grating pitches and sizes of the sub-resolution grating lines thus obtaining different mask lay-outs as function of the sub-resolution grating pitch and as function of the size of the sub-resolution grating lines,
- simulating lithographic imaging of the mask pattern for each of said different mask lay-outs as function of the sub-resolution grating pitch and the size of the sub-resolution grating lines thus obtaining image quality parameters, and
- selecting the mask lay-out having the best image quality parameters.

14. A system (300) according to any of claims 12 or 13, wherein the system (300) is implemented as a computer program product for, when executing on a processing means, carrying out one of the methods according to claims 9 to 11.

15. A data carrier storing a computer program product, when executed on a processing means, carrying out one of the method according to claims 9 to 11.

**FIG. 1**

200

Repetitively defining a mask lay-out for a plurality of sizes and/or pitches of the sub-resolution grating lines of one or more sub-resolution gratings in the mask lay-out thus obtaining different mask lay-outs as function of the size of the sub-resolution grating lines

210

simulating lithographic imaging (220) of the mask pattern for each of said different mask lay-outs as function of the size and/or pitch of the sub-resolution grating lines and obtaining imaging quality parameters based thereon.

220

Selecting the mask lay-out resulting in the best imaging quality

230

**FIG. 2**

310

320

300

330

FIG. 3

FIG. 4

**FIG. 5**

**FIG. 6**

**FIG. 7**

FIG. 8

Europäisches
Patentamt

European
Patent Office

Office européen
des brevets

# EUROPEAN SEARCH REPORT

**Application Number**

EP 24 15 8459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHAO RONGKUO ET AL: "Computational lithography solutions to support EUV high-NA patterning", 20230428, vol. 12495, 28 April 2023 (2023-04-28), pages 124950R-124950R, XP060179987, ISSN: 0277-786X, DOI: 10.1117/12.2660858 ISBN: 978-1-5106-6097-7 * abstract * * page 8 - page 11; figure 9 * ----- | 1-4,7-15 | INV. G03F1/36 G03F1/70 G03F7/00 |
| A | EP 1 357 427 A2 (ASML NETHERLANDS BV [NL]) 29 October 2003 (2003-10-29) * paragraphs [0013] - [0014] * * paragraph [0021] * * paragraphs [0030] - [0031]; figures 2-4 * ----- | 1-15 | |

**TECHNICAL FIELDS
SEARCHED       (IPC)**

G03F

The present search report has been drawn up for all claims

| Place of search | Date of completion of the search | Examiner |
|---|---|---|
| Munich | 31 July 2024 | van Toledo, Wiebo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

**EP 4 603 908 A1**

## ANNEX TO THE EUROPEAN SEARCH REPORT
## ON EUROPEAN PATENT APPLICATION NO.

EP 24 15 8459

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2024

| Patent document cited in search report | Publication date | Patent family member(s) | Publication date |
|---|---|---|---|
| EP 1357427 A2 | 29-10-2003 | NONE | |

For more details about this annex : see Official Journal of the European Patent Office, No. 12/82

EPO FORM P0459